# EUROPEAN PATENT APPLICATION

(11) **EP 1 953 262 A1**
(43) Date of publication of application: **06.08.2008**
(21) Application number: 06811039.4
(22) Date of filing: 02.10.2006
(51) Int. Cl.: C23C 18/18, H05K 3/18

(54) **CATALYST TREATMENT METHOD, ELECTROLESS PLATING METHOD, AND METHOD FOR FORMATION OF CIRCUIT BY USING THE ELECTROLESS PLATING METHOD**

(30) Priority: 04.10.2005 JP 2005291212
(71) Applicant: ALPS ELECTRIC CO., LTD., Tokyo 145-8501 (JP)
(72) Inventor: MITSUMORI, Kenichi, Tokyo 145-8501 (JP)
(74) Representative: Klunker . Schmitt-Nilson . Hirsch
(86) International application number: PCT/JP2006/319691
(87) International publication number: WO 2007/043380

(57) **Abstract**

A catalyst layer which enables an electroless plating method to be carried out can be formed by an inexpensive and simple process without using palladium.

There are provided a tin treatment step of bringing a substrate into contact with a tin compound aqueous solution containing a tin compound; after the tin treatment step, a copper treatment step of bringing a substrate 1 into contact with a copper compound aqueous solution containing a copper compound; after the copper treatment step, a diluted sulfuric acid treatment step of bringing the substrate 1 into contact with diluted sulfuric acid; after the diluted sulfuric acid treatment step, a plating treatment step of bringing the substrate 1 into contact with a plating solution to form a copper plating film 2; and after the plating treatment step, a heat treatment step of heating the substrate 1 in an atmosphere substantially containing no oxygen and hydrogen.

## Description

### Technical Field

The present invention relates to a catalytic treatment method which enables an electroless plating method to form a plating film on a substrate, an electroless plating method using this catalytic treatment method, and a method of forming a circuit using this electroless plating method.

### Background Art

Heretofore, for example, as a method for forming a plating film on a substrate made of a glass, a ceramic, or the like, or further on a substrate made of a resin or the like, an electroless plating method has been known.

According to this electroless plating method, for example, after a catalyst layer is formed on a nonconductive glass substrate which is processed beforehand by a degreasing treatment, this glass substrate is immersed in a plating solution, so that a plating film is formed on the glass substrate. In this method, in a catalytic treatment method forming the catalyst layer on the glass substrate, because of a significantly high catalytic activity and the like, palladium has been generally used.

However, in recent years, by the reasons, such as a recent rapid increase in price of palladium, it has been desired to use an inexpensive substance other than palladium to form a catalyst layer.

Accordingly, for example, as disclosed in Patent Document 1 or 2, in a catalytic treatment method forming a catalyst layer that enables an electroless plating method to form a plating film, a catalytic treatment method has been conceived which forms a catalyst layer using a reducing agent instead of using expensive palladium.

According to this catalytic treatment method, for example, after a glass substrate is sequentially immersed in a tin compound aqueous solution containing a tin compound and a copper compound aqueous solution containing a copper compound, the substrate is immersed in a reducing agent. aqueous solution containing a reducing agent, so that a catalyst layer is formed by reduction of metal copper. In addition, when the glass substrate provided with the catalyst layer is immersed in a copper plating solution, a copper plating film is formed on the glass substrate.

However, in the catalytic treatment method as described above, a reducing agent must be used in order to form a catalyst layer, and as a result, there have been problems in that a process for the catalytic treatment method becomes complicated, and manufacturing cost of a plating substrate on which a catalyst layer is formed by the above catalytic treatment method is increased. Furthermore, when the reducing agent is discarded, a problem of waste liquid treatment also arises.

Patent Document 1: Japanese Unexamined Patent Application Publication No. 2002-309376

Patent Document 2: Japanese Unexamined Patent Application Publication No. 7-197266

### Disclosure of Invention

### Problems to be Solved by the Invention

In consideration of the problems described above, the present invention has been conceived, and an object of the present invention is to provide a catalytic treatment method capable of forming a catalyst layer, which enables an electroless plating method to be carried out, by an inexpensive and simple process without using palladium, an electroless plating method, and a method for forming a circuit using an electroless plating method.

### Means for Solving the Problems

In order to achieve the above object, a catalytic treatment method of the present invention comprises: a tin treatment step of bringing a substrate into contact with a tin compound aqueous solution containing a tin compound; after the tin treatment step, a copper treatment step of bringing the substrate into contact with a copper compound aqueous solution containing a copper compound; and after the copper treatment step, a diluted sulfuric acid treatment step of bringing the substrate into contact with diluted sulfuric acid.

In addition, according to the above catalytic treatment method of the present invention, the above copper compound aqueous solution preferably has sulfuric acid acidity.

According to the present invention, since the diluted sulfuric acid treatment step is performed after the tin treatment step and the copper treatment step, copper oxide is removed which is formed when metal copper is deposited by reaction between tin and copper, and the metal copper can be formed into a catalyst layer functioning as a catalyst. Accordingly, without using palladium, the catalyst layer can be formed on the substrate.

Another catalytic treatment method of the present invention comprises: a tin treatment step of bringing a substrate into contact with a tin compound aqueous solution containing a tin compound; and after the tin treatment step, a copper treatment step of bringing the substrate into contact with a copper compound aqueous solution which contains a sulfuric acid-acidic copper compound.

According to the present invention, since the copper compound aqueous solution having sulfuric-acid acidity is used in the copper treatment step, without performing the diluted sulfuric acid treatment step, the catalyst layer can be formed on the substrate, and hence the process for forming a catalysis layer can be simplified.

According to the above catalytic treatment methods of the present invention, the tin treatment step and the copper treatment step may be sequentially repeated a plurality of times.

According to the present invention, when the tin treatment step and the copper treatment step are repeatedly performed, the addition amount of copper to be used as the catalyst layer can be increased.

An electroless plating method of the present invention comprises: a tin treatment step of bringing a substrate into contact with a tin compound aqueous solution containing a tin compound; after the tin treatment step, a copper treatment step of bringing the substrate into contact with a copper compound aqueous solution containing a copper compound; after the copper treatment step, a diluted sulfuric acid treatment step of bringing the substrate into contact with diluted sulfuric acid; and after the diluted sulfuric acid treatment, a plating treatment step of bringing the substrate into contact with a plating solution to form a plating film.

In addition, in the above electroless plating method of the present invention, the copper compound aqueous solution preferably has sulfuric acid acidity.

According to the present invention, when the diluted sulfuric acid treatment step is performed after the tin treatment step and the copper treatment step, copper oxide is removed which is formed when metal copper is deposited by reaction between tin and copper, and the metal copper can be formed in to a catalysis layer functioning as a catalyst. Accordingly, without using palladium, the catalyst layer can be formed on the substrate.

Another electroless plating method of the present invention comprises: a tin treatment step of bringing a substrate into contact with a tin compound aqueous solution containing a tin compound; after the tin treatment step, a copper treatment step of bringing the substrate into contact with a copper compound aqueous solution which contains a sulfuric acid-acidic copper compound; and after the copper treatment step, a plating treatment step of bringing the substrate into contact with a plating solution to form a plating film.

According to the present invention, since the copper compound aqueous solution having sulfuric acid acidity is used in the copper treatment step, without performing a diluted sulfuric acid treatment step, the catalyst layer can be formed on the substrate, and hence the process for forming a catalysis layer can be simplified.

In the above electroless plating methods of the present invention, after the plating treatment step, a heat treatment step of heating the substrate in an atmosphere substantially containing no oxygen and hydrogen may be further performed.

According to the present invention, when the heat treatment step is performed after the plating treatment step, since it is believed that tin is bonded to a constituent element of the substrate at the interface thereof with the catalyst layer, the catalyst layer can be satisfactorily adhered to the substrate. Accordingly, it is believed that the adhesion between the plating film and the substrate can be improved.

A method for forming a circuit using an electroless plating method, of the present invention, comprises: a tin treatment step of bringing a substrate into contact with a tin compound aqueous solution containing a tin compound; after the tin treatment step, a copper treatment step of bringing the substrate into contact with a copper compound aqueous solution containing a copper compound; after the copper treatment step, an oxidation treatment step of irradiating ultraviolet rays to an arbitrary portion of metal copper formed on the substrate by deposition so as to oxidize an exposed portion of the metal copper; a diluted sulfuric acid treatment step of bringing the substrate into contact with diluted sulfuric acid to remove oxide copper so as to form the metal copper into an arbitrary pattern; and a plating treatment step of bringing the substrate into contact with a plating solution to form a plating film using the metal copper as nuclei.

According to the present invention, after metal copper is deposited by reaction between tin and copper by the tin treatment step and the copper treatment step and is then irradiated with ultraviolet rays in the oxidation treatment step to oxidize an arbitrary part of the metal copper, by performing the diluted sulfuric acid treatment step, the copper oxide can be removed. Accordingly, without using palladium, the catalyst layer can be formed on the substrate, and without using a resist, a plating film having an arbitrary pattern can be formed.

According to the above method for forming a circuit using an electroless plating method, of the present invention, the wavelength of the ultraviolet rays used in the oxidation treatment step is preferably 254 nm or less.

According to the present invention, when the wavelength of the ultraviolet rays irradiated in the oxidation treatment step is set to 254 nm or less, since metal copper can be sufficiently oxidized, the oxidation efficiency can be improved, and a circuit having a dense and superior pattern can be formed.

The method for forming a circuit using an electroless plating method, of the present invention, may further comprise, after the diluted sulfuric acid treatment step and before the plating treatment step, a palladium treatment step of bringing the substrate into contact with a palladium solution containing palladium.

According to the present invention, since palladium is applied, the rate of forming a plating film can be increased.
As a result, since a uniform plating film can be formed, the stability in manufacturing a plating film can be improved. Advantages

As has thus been described, according to the catalytic treatment method, the electroless plating method, and the method for forming a circuit using an electroless plating method, of the present invention, a catalyst layer can be formed which enables electroless plating to be carried out without using palladium, and hence the catalyst layer can be formed by an inexpensive and simple process.

In addition, according to the method for forming a circuit using an electroless plating method, of the present invention, a circuit pattern can be formed by a simple method without using a resist. In addition, a material forming the resist can be omitted, and hence the manufacturing cost can be reduced.

### Brief Description of Drawings

Fig. 1 is a flowchart showing one embodiment of steps of a catalytic treatment method and an electroless plating method, of the present invention.
Fig. 2(a) to 2(f) are schematic views each showing a step of the electroless plating method shown in Fig. 1.
Fig. 3 is a flowchart showing one embodiment of steps of a method for forming a circuit using an electroless plating method, of the present invention.
Fig. 4(a) to 4(h) are schematic views each showing a step of the method for forming a circuit using an electroless plating method shown in Fig. 3.

### Best Modes for Carrying Out the Invention

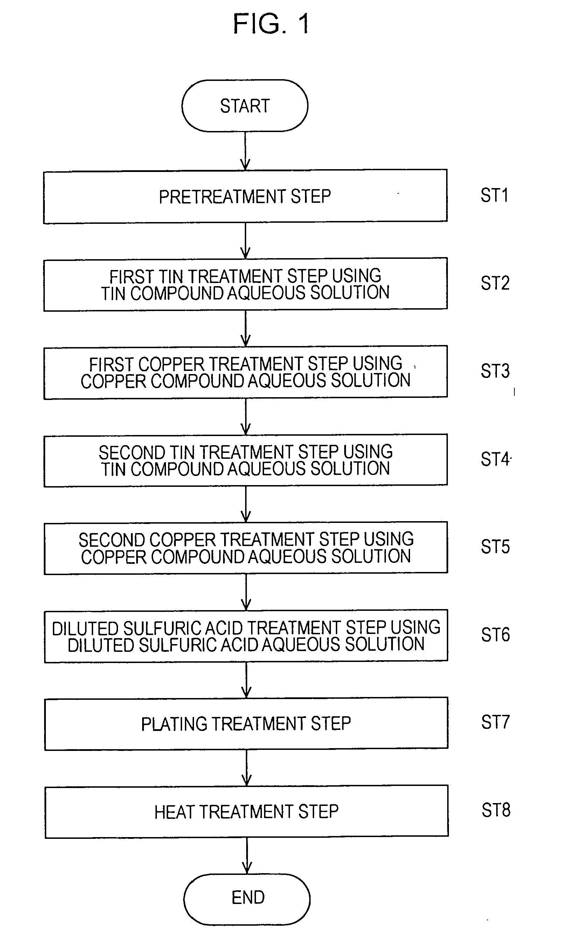

Hereinafter, a catalytic treatment method, an electroless plating method using this catalytic treatment method, and a method for forming a circuit using this electroless plating method, according to embodiments of the present invention, will be described with reference to Figs. 1 to 4.

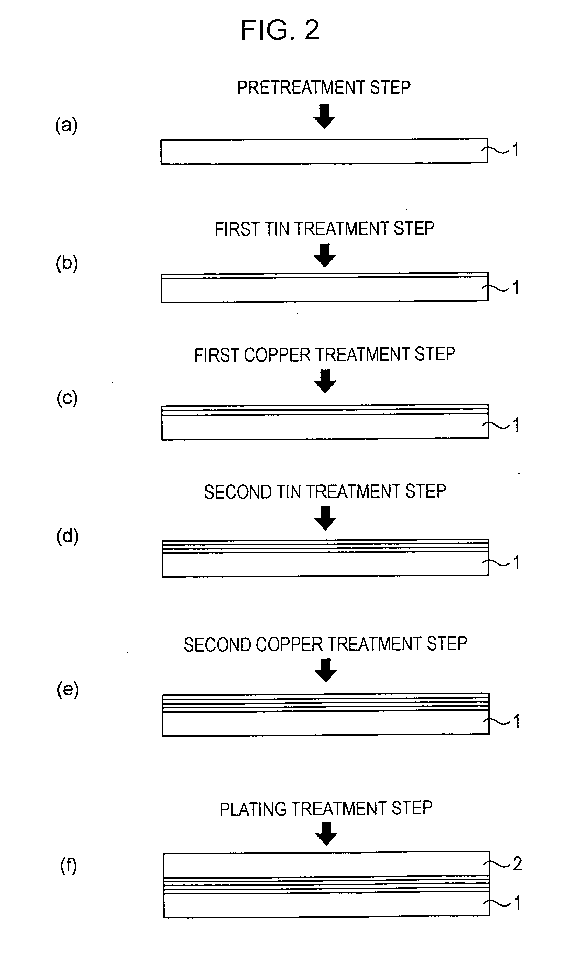

Fig. 1 is a flowchart showing steps of an electroless plating method using the catalytic treatment method of this embodiment, and Figs. 2(a) to 2(f) are schematic views each showing a step of the electroless plating method of this embodiment. In this embodiment, the case in which a copper plating film is formed on a substrate will be described; however, the catalytic treatment method and the electroless plating method of the present invention are not limited to the case in which a copper plating film is formed and may also be applied when various plating films are formed.

As shown in Figs. 1 and 2(a), in this embodiment, first, a pretreatment step, such as degreasing and/or cleaning, of removing impurities, such as dust and grease, adhering to a substrate 1 is performed thereon (ST1). This pretreatment step may be performed by a known method.

The substrate 1 used in this embodiment is not particularly limited, and for example, besides a glass substrate, a ceramic substrate, and the like, various substrates 1, such as resin substrates using a polyimide, an epoxy resin, a polycarbonate, and the like, may also be used.

After the pretreatment step, as shown in Fig. 2(b), a first tin treatment step in which the substrate 1 is brought into contact with a tin aqueous solution containing a tin compound by immersion or the like is performed (ST2).

As the tin compound used in the first tin treatment step, for example, various water soluble tin compounds, such as stannous sulfate and stannous chloride, may be used, and in addition, a mixture of tin compounds may also be used.

After the tin treatment step, as shown in Fig. 2(c), a first copper treatment step in which the substrate 1 is brought into contact with a copper compound aqueous solution containing a copper compound by immersion or the like is performed (ST3), and by reaction between tin and copper, metal copper is deposited on the substrate 1.

As the copper compound used in the first copper treatment step, for example, various water soluble copper compounds, such as copper sulfate, copper chloride, copper nitrate, and copper acetate, may be used, and in addition, although a mixture of copper compounds may also be used, a sulfuric acid-acidic copper compound is preferably used.

After the first copper treatment step, as shown in Fig. 2(d), again, a second tin treatment step in which the substrate 1 is brought into contact with a tin compound aqueous solution containing a tin compound by immersion or the like is performed (ST4).

As the tin compound used in the second tin treatment step, various water soluble tin compounds may be used as in the case of the tin compounds used in the first tin treatment step, and the same tin compound as that used in the first tin treatment step or a tin compound different therefrom may be used.

After the second tin treatment step, as shown in Fig. 2(e), again, a second copper treatment step in which the substrate 1 is brought into contact with a copper compound aqueous solution containing a copper compound by immersion or the like is performed (ST5).

As the copper compound used in the second copper treatment step, various water soluble copper compounds may be used as in the case of the copper compounds used in the first copper treatment step, and the same copper compound as that used in the first copper treatment step or a copper compound different therefrom may be used.

In this embodiment, the tin treatment step and the copper treatment step are repeated twice; however, the number of the steps to be repeated is not limited thereto, and the tin treatment step and the copper treatment step may be performed once or may be sequentially repeated three times or more.

After the second copper treatment step, a diluted sulfuric acid treatment step in which the substrate 1 is brought into contact with an aqueous solution containing diluted sulfuric acid by immersion or the like is performed (ST6). In the diluted sulfuric acid treatment step, copper oxide formed when metal copper is deposited on the substrate 1 can be removed by diluted sulfuric acid; hence, the metal copper is formed as a catalyst layer functioning as a catalyst, and the catalyst layer can be formed on the substrate 1.

In addition, in at least one of the first and the second copper treatment steps, when a copper compound aqueous solution having sulfuric acid acidity is used, copper oxide is removed in the above copper treatment step, and the metal copper can be made to function as a catalyst layer; hence, in this case, the diluted sulfuric acid treatment step may be omitted.

Subsequently, a plating treatment step in which the substrate 1 is immersed in a copper plating solution is performed (ST7). Accordingly, as shown in Fig. 2(f), a copper plating film 2 is formed on the substrate 1 using the metal copper, which forms the catalyst layer, as nuclei.

For various plating conditions of the plating treatment step, a known electroless plating method may be used, and as the copper plating solution, for example, there may be used a copper plating solution containing, besides copper ions and nickel ions, a complexing agent, such as sodium potassium tartrate tetrahydrate, a reducing agent, such as formaldehyde, a pH adjuster, such as sodium hydroxide, a chelating agent, and the like.

Furthermore, the substrate 1 provided with the copper plating film 2 is sufficiently cleaned and then dried, and for example, in an inert gas atmosphere containing nitrogen gas or the like, or in an atmosphere, such as an evacuated atmosphere, substantially containing no oxygen and hydrogen, a heat treatment step of performing heating at a predetermined temperature for a predetermined heat treatment time is carried out (ST8). As a result, the copper plating film 2 having a high adhesion can be formed on the substrate 1.

Next, an effect of the electroless plating method using the catalytic treatment method of this embodiment will be described.

According to this embodiment, after the tin treatment step and the copper treatment step, by performing the diluted sulfuric acid treatment step, copper oxide formed when metal copper is deposited by reaction between tin and copper is removed, and hence the metal copper can be made to function as a catalyst. Accordingly, without using palladium, the catalyst layer can be formed on the substrate 1.

In addition, in the copper treatment step, when a copper compound having sulfuric acid acidity is used, without performing the diluted sulfuric acid treatment step, the metal copper deposited on the substrate 1 can be made to function as a catalyst.

Accordingly, without using palladium, the catalyst layer that enables electroless plating to be carried out can be formed, and as a result, by an inexpensive and simple process, the catalyst layer can be formed on the substrate 1.

In addition, in the copper treatment step, when a copper compound having sulfuric acid acidity is used, since the catalyst layer can be formed without performing the diluted sulfuric acid treatment step, the process for forming a catalyst layer can be further simplified.

Furthermore, after the plating treatment step, when the heat treatment step is performed, since it is believed that tin and a constituent element of the substrate are bonded to each other at the interface between the substrate and the catalyst layer, the catalyst layer can be satisfactorily adhered to the substrate. Accordingly, the adhesion between the copper plating film 2 and the substrate 1 can be improved.

In addition, after the first tin treatment step and the first copper treatment step, when the second tin treatment step and the second copper treatment step are repeatedly performed, the addition amount of copper to be used as the catalyst layer can be increased.

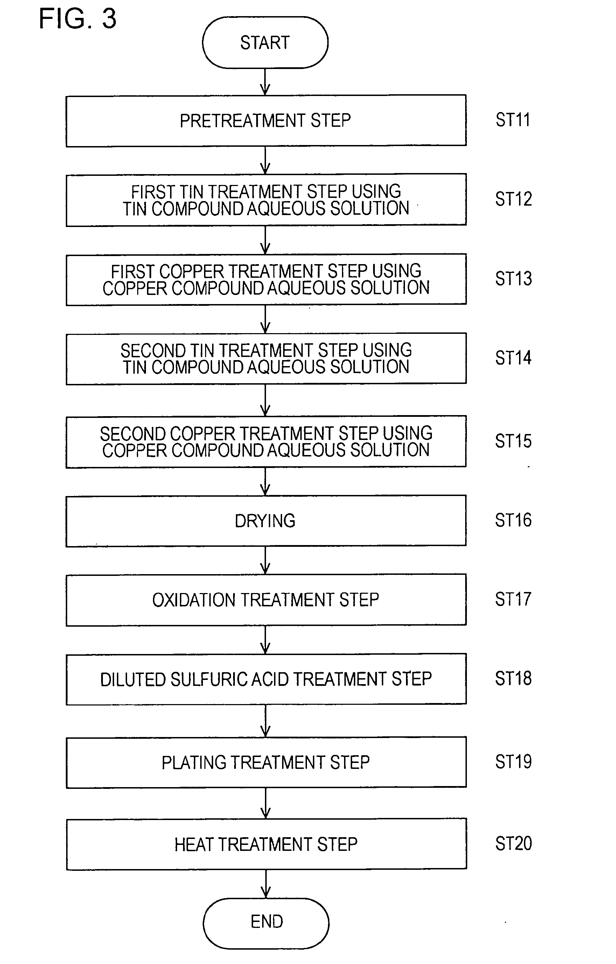

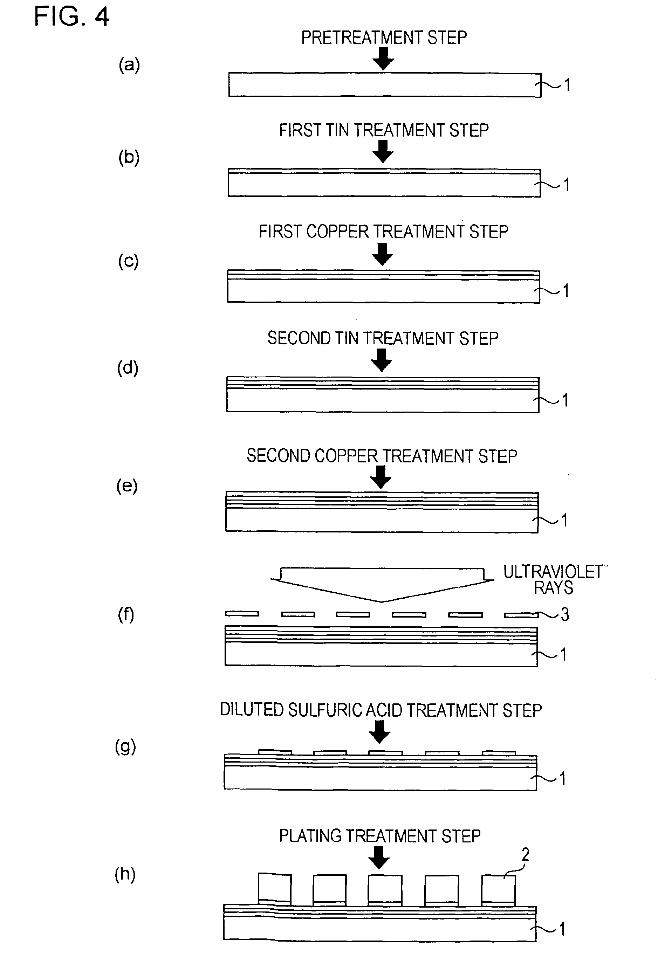

Next, the embodiment of the method for forming a circuit using an electroless plating method, of the present invention, will be described with reference to Figs. 3, and 4 (a) to 4 (h) .

In the method for forming a circuit using an electroless plating method, of this embodiment, the case in which the circuit is formed from the copper plating film 2 will be described; however, the method for forming a circuit of the present invention is not limited thereto and may be applied to the case in which a circuit is formed using various plating films.

In addition, as a substrate 1 used in this embodiment, the substrate 1 similar to the substrate 1 used in the above catalytic treatment method and that of the above electroless plating method may be used.

In the method for forming a circuit using an electroless plating method, of this embodiment, by the process similar to that of the above catalytic treatment method, after a pretreatment step, such as degreasing and/or cleaning, is performed on the substrate 1 (ST11) as shown in Fig. 3 and 4(a), a first tin treatment step (ST12) as shown in Fig. 4(b), a first copper treatment step (ST13) as shown in Fig. 4(c), a second tin treatment step (ST14) as shown in Fig. 4(d), and a second copper treatment step (ST15) as shown in Fig. 4(e) are sequentially performed on the substrate 1, so that metal copper is deposited on the substrate 1.

As for treatment conditions of the solution and the like of the treatment steps, the same treatment conditions as those in the above catalytic treatment method may be used. For example, in this embodiment, the tin treatment step and the copper treatment step are repeated twice; however, the number of the steps to be repeated is not limited thereto, and the tin treatment step and the copper treatment step may be performed once or may be repeated three times or more.

Next, after the substrate 1 is dried (ST16), the metal copper on the substrate 1 is irradiated with ultraviolet rays through a mask 3 having an arbitrary pattern, as shown in Fig. 4(f), so that an oxidation treatment step in which exposed parts of the metal copper are oxidized is performed (ST17) .

In this oxidation treatment step, when ultraviolet rays are irradiated, for example, a low-pressure mercury lamp may be used. In addition, as for the wavelength of ultraviolet rays to be irradiated, when a low-pressure mercury lamp is used, the wavelength at which the water bonding is dissociated is 254 nm, and when the wavelength of ultraviolet rays is longer than 254 nm, metal copper cannot be sufficiently oxidized; hence, the wavelength is preferably 254 nm or less.

After the oxidation treatment step, a diluted sulfuric acid treatment step in which the substrate 1 is brought into contact with a diluted sulfuric acid aqueous solution containing diluted sulfuric acid to remove copper oxide, which includes metal copper oxidized in the oxidation treatment step, is performed (ST18). Accordingly, as shown in Fig. 4(g), the metal copper deposited on the substrate 1 can be formed to have an arbitrary pattern.

In addition, after the diluted sulfuric acid treatment step, by a plating treatment step in which the substrate 1 is immersed in a copper plating solution (ST19), the copper plating film 2 is formed using the metal copper formed into an arbitrary pattern as nuclei, as shown in Fig. 4(h). Accordingly, a circuit of the copper plating film 2 having an arbitrary pattern can be formed.

For various plating treatment conditions of the plating treatment step of this embodiment, a known electroless copper plating method may be used as in the case of the plating treatment step of the electroless plating method.

Furthermore, after the substrate 1 provided with the copper plating film 2 is sufficiently cleaned and then dried, for example, in an inert gas atmosphere containing nitrogen or the like, or in an atmosphere, such as an evacuated atmosphere, substantially containing no oxygen and hydrogen, a heat treatment step of performing heating at a predetermined temperature for a predetermined heat treatment time is carried out (ST20), so that the copper plating film 2 having a high adhesion can be formed on the substrate 1.

Next, an effect of the method for forming a circuit using an electroless plating method, of this embodiment, will be described.

According to this embodiment, by the tin treatment step and the copper treatment step, the metal copper is deposited by reaction between tin and copper, and after the arbitrary parts of the metal copper are oxidized by irradiation of ultraviolet rays on the metal copper in the oxidation treatment step, copper oxide can be removed by diluted sulfuric acid. Accordingly, the catalyst layer can be formed on the substrate 1 without using palladium, and in addition, without using a resist, the copper plating film 2 having an arbitrary pattern can be formed.

Hence, without using palladium, the catalyst layer that enables electroless plating to be carried out can be formed, and as a result, by an inexpensive and simple process, the catalyst layer can be formed.

In addition, since the copper plating film 2 having an arbitrary pattern can be formed without using a resist, a circuit pattern can be formed by a simple process. In addition, a material forming the resist can be omitted, and hence the manufacturing cost of the circuit can be reduced.

Furthermore, when the wavelength of ultraviolet rays irradiated in the oxidation treatment step is set to 254 nm or less, the metal copper can be sufficiently oxidized; hence, the oxidation efficiency can be improved, and in addition, a circuit having a dense and superior pattern can be formed.

In the method for forming a circuit using an electroless plating method, described above, after the diluted sulfuric acid treatment step and before the plating treatment step, the substrate 1 provided with a catalyst layer having an arbitrary pattern may be immersed in a palladium aqueous solution containing palladium so as to perform a palladium treatment step in which palladium is applied to the surface of the metal copper. As a result, since palladium is applied, the rate of forming the plating film can be increased. Hence, since a uniform plating film can be formed, the stability in forming a circuit can be improved.

The present invention is not limited to the above embodiments and may be variously changed and modified whenever necessary.

### Examples

### (Example 1)

As a substrate, a glass substrate of borosilicate glass having an outer diameter of 100 mm and a thickness of 0.7 mm was prepared, and as a pretreatment step, the above glass substrate was degreased and cleaned for 3 minutes using a sodium hydroxide aqueous solution having a sodium hydroxide concentration of 15% and a solution temperature of 50°C.

Subsequently, in a tin treatment step, a hydrochloric acid-acidic stannous chloride aqueous solution having a stannous chloride concentration of 70 mmol/L and a solution temperature of 23°C was prepared, and the above glass substrate was immersed in the above stannous chloride aqueous solution for 3 minutes. Next, in a copper treatment step, a copper sulfate aqueous solution having a copper sulfate concentration of 7.2 mmol/L and a solution temperature of 23°C was prepared, and the above glass substrate was immersed in the above copper sulfate aqueous solution for 3 minutes, so that metal copper was deposited on the glass substrate.

Furthermore, in a diluted sulfuric acid treatment step, a diluted sulfuric acid aqueous solution having a sulfuric acid concentration of 0.05 mol/L and a solution temperature of 23°C was prepared, and the above glass substrate was immersed in the above diluted sulfuric acid aqueous solution for 1 minute, so that copper oxide formed when the metal copper was deposited was removed.

Next, a plating treatment was performed on the above glass substrate. In a plating treatment step of this Example 1, a copper plating solution was prepared which contained 2.5 g/L (0.039 mol/L) copper ions and 0.138 g/L of nickel ions, and which also contained sodium potassium tartrate tetrahydrate (Rochelle salt) as a complexing agent, approximately 0.2% of formaldehyde as a reducing agent, and approximately 0.1% of a chelating agent. Furthermore, in the above copper plating solution, approximately 1.5 g/L of sodium hydroxide (NaOH) as a pH adjuster was contained, and the pH was adjusted at 12.6. Subsequently, the glass substrate was immersed in the copper plating solution at a controlled solution temperature of 30°C for 1 hour, so that a copper plating film was formed on the substrate.

When the copper plating film was formed as described above, the rate of forming a copper plating was approximately 2,000 Å/h, and by this process, without using palladium, a catalyst layer could be formed which enabled an electroless plating method to form a copper plating film.

### (Example 2)

As a substrate, a glass substrate of borosilicate glass having an outer diameter of 100 mm and a thickness of 0.7 mm was prepared, and as a pretreatment step, the above glass substrate was degreased and cleaned for 3 minutes using.a sodium hydroxide aqueous solution having a sodium hydroxide concentration of 15% and a solution temperature of 50°C.

Subsequently, in a first tin treatment step, a hydrochloric acid-acidic stannous chloride aqueous solution having a stannous chloride concentration of 70 mmol/L and a solution temperature of 23°C was prepared, and the above glass substrate was immersed in the above stannous chloride aqueous solution for 3 minutes. Next, in a first copper treatment step, a copper sulfate aqueous solution having a copper sulfate concentration of 7.2 mmol/L and a solution temperature of 23°C was prepared, and the above glass substrate was immersed in the above copper sulfate aqueous solution for 3 minutes.

Furthermore, after the glass substrate was immersed in a stannous chloride aqueous solution in a second tin treatment step under the same treatment conditions as those of the first tin treatment step, the glass substrate was immersed in a copper sulfate aqueous solution in a second copper treatment step under the same treatment conditions as those of the first copper treatment step, so that metal copper was deposited on the glass substrate.

Furthermore, in a diluted sulfuric acid treatment step, a diluted sulfuric acid aqueous solution having a sulfuric acid concentration of 0.5 mol/L and a solution temperature of 23°C was prepared, and the above glass substrate was immersed in the above diluted sulfuric acid aqueous solution for 1 minute, so that copper oxide was removed.

Next, a plating treatment was performed on the above glass substrate. In a plating treatment step of this Example 2, a copper plating solution was prepared which contained 2.5 g/L (0.039 mol/L) copper ions and 0.138 g/L of nickel ions, and which also contained sodium potassium tartrate tetrahydrate (Rochelle salt) as a complexing agent, approximately 0.2% of formaldehyde as a reducing agent, and approximately 0.1% of a chelating agent. Furthermore, in the above copper plating solution, approximately 1.5 g/L of sodium hydroxide (NaOH) as a pH adjuster was contained, and the pH was adjusted at approximately 12.6. Subsequently, the glass substrate was immersed in the copper plating solution at a controlled solution temperature of 30°C for 1 hour, so that a copper plating film was formed on the substrate.

When the copper plating film was formed as described above, the rate of forming a copper plating was approximately 9,000 Å/h, and the copper plating film could be formed at a fast rate as compared to that of the Example 1. In addition, the resistivity of the copper plating film was approximately 3 to 3.5 µΩ·cm, and a superior copper plating film having high frequency properties could be formed.

### (Example 3)

As a substrate, a glass substrate of borosilicate glass having an outer diameter of 100 mm and a thickness of 0.7 mm was prepared, and as a pretreatment step, the above glass substrate was degreased and cleaned for 3 minutes using a sodium hydroxide aqueous solution having a sodium hydroxide concentration of 15% and a solution temperature of 50°C.

Subsequently, in a first tin treatment step, a hydrochloric acid-acidic stannous chloride aqueous solution having a stannous chloride concentration of 70 mmol/L and a solution temperature of 23°C was prepared, and the above glass substrate was immersed in the above stannous chloride aqueous solution for 3 minutes. Next, in a first copper treatment step, a copper sulfate aqueous solution having a copper sulfate concentration of 7.2 mmol/L and a solution temperature of 23°C was prepared, and the above glass substrate was immersed in the above copper sulfate aqueous solution for 3 minutes.

Furthermore, in a second tin treatment step, after the glass substrate was immersed in a stannous chloride aqueous solution under the same treatment conditions as those of the first tin treatment step, in a second copper treatment step, the glass substrate was immersed in a copper sulfate aqueous solution under the same treatment conditions as those of the first copper treatment step, so that metal copper was deposited on the substrate.

Next, by a spin dry method, the glass substrate was rotated at a rotation rate of 3,000 rpm for 1 minute, so that drying was performed.

Subsequently, in an oxidation treatment step, using a low-pressure mercury lamp, the glass substrate was irradiated by ultraviolet rays having a wavelength of 254 nm and a light quantity of 150 mJ/cm² through a mask having an arbitrary pattern, so that exposed parts of the metal copper were oxidized.

Furthermore, in a diluted sulfuric acid treatment step, a diluted sulfuric acid aqueous solution having a sulfuric acid concentration of 0.5 mol/L and a solution temperature of 23°C was prepared, and the above glass substrate was immersed in the above diluted sulfuric acid aqueous solution for 1 minute, so that copper oxide was removed.

Next, a plating treatment was performed on the above glass substrate. In a plating treatment step of this Example 3, a copper plating solution was prepared which contained 2.5 g/L (0.039 mol/L) copper ions and 0.138 g/L of nickel ions, and which also contained sodium potassium tartrate tetrahydrate (Rochelle salt) as a complexing agent, approximately 0.2% of formaldehyde as a reducing agent, and approximately 0.1% of a chelating agent. Furthermore, in the above copper plating solution, approximately 1.5 g/L of sodium hydroxide (NaOH) as a pH adjuster was contained, and the pH was adjusted at approximately 12.6. Subsequently, the glass substrate was immersed in the copper plating solution at a controlled solution temperature of 30°C for 1 hour, so that a copper plating film was formed on the substrate.

Next, a heat treatment was performed on the above glass substrate at a heat treatment temperature of 400°C for a heat treatment time of 1 hour in a nitrogen atmosphere, and from the copper plating film thus formed, a circuit was formed on the glass substrate.

When the copper plating film was formed as described above, the rate of forming a copper plating was approximately 9,000 Å/h, and the copper plating film could be formed at a fast rate as compared to that of the Example 1. In addition, the resistivity of the copper plating film was approximately 3 to 3.5 µΩ·cm, and a circuit of a superior copper plating film having high frequency properties could be formed. Furthermore, the tensile strength of the copper plating film with respect to the glass substrate was 40 Mpa or more, and hence the adhesion of the copper plating film could be improved. In addition, a circuit having a fine wiring L/S (Line&Space) of 10 µm could be formed.

### (Example 4)

As a substrate, a glass substrate of borosilicate glass having an outer diameter of 100 mm and a thickness of 0.7 mm was prepared, and as a pretreatment step, the above glass substrate was degreased and cleaned for 3 minutes using a sodium hydroxide aqueous solution having a sodium hydroxide concentration of 15% and a solution temperature of 50°C.

Subsequently, in a first tin treatment step, a hydrochloric acid-acidic stannous chloride aqueous solution having a stannous chloride concentration of 70 mmol/L and a solution temperature of 23°C was prepared, and the above glass substrate was immersed in the above stannous chloride aqueous solution for 3 minutes. Next, in a first copper treatment step, a copper sulfate aqueous solution having a copper sulfate concentration of 7.2 mmol/L and a solution temperature of 23°C was prepared, and the above glass substrate was immersed in the above copper sulfate aqueous solution for 3 minutes.

Furthermore, in a second tin treatment step, after the glass substrate was immersed in a stannous chloride aqueous solution under the same treatment conditions as those of the first tin treatment step, in a second copper treatment step, the glass substrate was immersed in a copper sulfate aqueous solution under the same treatment conditions as those of the first copper treatment step, so that metal copper was deposited on the glass substrate.

Next, by a spin dry method, the glass substrate was rotated at a rotation rate of 3,000 rpm for 1 minute, so that drying was performed.

Subsequently, in an oxidation treatment step, using a low-pressure mercury lamp, the glass substrate was irradiated by ultraviolet rays having a wavelength of 254 nm and a light quantity of 150 mJ/cm² with a mask having an arbitrary pattern, so that exposed parts of the metal copper were oxidized.

Furthermore, in a diluted sulfuric acid treatment step, a diluted sulfuric acid aqueous solution having a sulfuric acid concentration of 0.5 mol/L and a solution temperature of 23°C was prepared, and the above glass substrate was immersed in the above diluted sulfuric acid aqueous solution for 1 minute, so that copper oxide was removed.

Subsequently, in a palladium treatment, a palladium aqueous solution having a palladium concentration of 3×10⁻³ mol/L and a solution temperature of 30°C was prepared, and the glass substrate provided with a catalyst layer having an arbitrary pattern was immersed in the above palladium aqueous solution for 3 minutes.

Next, a plating treatment was performed on the above glass substrate. In a plating treatment step of this Example 2, a copper plating solution was prepared which contained 2.5 g/L (0.039 mol/L) copper ions and 0.138 g/L of nickel ions, and which also contained sodium potassium tartrate tetrahydrate (Rochelle salt) as a complexing agent, approximately 0.2% of formaldehyde as a reducing agent, and approximately 0.1% of a chelating agent. Furthermore, in the above copper plating solution, approximately 1.5 g/L of sodium hydroxide (NaOH) as a pH adjuster was contained, and the pH was adjusted at approximately 12.6. Subsequently, the glass substrate was immersed in the copper plating solution at a controlled solution temperature of 30°C for 1 hour, so that a copper plating film was formed on the substrate.

Next, a heat treatment was performed on the above glass substrate at a heat treatment temperature of 400°C for a heat treatment time of 1 hour in a nitrogen atmosphere, and from the copper plating film thus formed, a circuit was formed on the glass substrate.

When the copper plating film was formed as described above, the rate of forming a copper plating was approximately 12,000 Å/h, and the copper plating film could be formed at a fast rate as compared to that of the Examples 1 to 3. In addition, the resistivity of the copper plating film was approximately 3 to 3.5 µΩ·cm, and a circuit of a superior copper plating film having high frequency properties could be formed. Furthermore, the tensile strength of the copper plating film with respect to the glass substrate was 40 Mpa or more, and hence the adhesion of the copper plating film could be improved. In addition, a circuit having a fine wiring L/S (Line&Space) of 10 µm could be formed.

## Claims

1. A catalytic treatment method comprising:
a tin treatment step of bringing a substrate into contact with a tin compound aqueous solution containing a tin compound;
after the tin treatment step, a copper treatment step of bringing the substrate into contact with a copper compound aqueous solution containing a copper compound; and
after the copper treatment step, a diluted sulfuric acid treatment step of bringing the substrate into contact with diluted sulfuric acid.

2. The catalytic treatment method according to Claim 1, wherein the copper compound aqueous solution has sulfuric acid acidity.

3. A catalytic treatment method comprising:
a tin treatment step of bringing a substrate into contact with a tin compound aqueous solution containing a tin compound; and
after the tin treatment step, a copper treatment step of bringing the substrate into contact with a copper compound aqueous solution which contains a sulfuric acid-acidic copper compound.

4. The catalytic treatment method according to one of Claims 1 to 3, wherein the tin treatment step and the copper treatment step are sequentially repeated a plurality of times.

5. An electroless plating method comprising:
a tin treatment step of bringing a substrate into contact with a tin compound aqueous solution containing a tin compound;
after the tin treatment step, a copper treatment step of bringing the substrate into contact with a copper compound aqueous solution containing a copper compound;
after the copper treatment step, a diluted sulfuric acid treatment step of bringing the substrate into contact with diluted sulfuric acid; and
after the diluted sulfuric acid treatment, a plating treatment step of bringing the substrate into contact with a plating solution to form a plating film.

6. The electroless plating method according to Claim 5, wherein the copper compound aqueous solution has sulfuric acid acidity.

7. An electroless plating method comprising:
a tin treatment step of bringing a substrate into contact with a tin compound aqueous solution containing a tin compound;
after the tin treatment step, a copper treatment step of bringing the substrate into contact with a copper compound aqueous solution which contains a sulfuric acid-acidic copper compound; and
after the copper treatment step, a plating treatment step of bringing the substrate into contact with a plating solution to form a plating film.

8. The electroless plating method according to one of Claims 5 to 7, further comprising, after the plating treatment step, a heat treatment step of heating the substrate in an atmosphere substantially containing no oxygen and hydrogen.

9. A method for forming a circuit using an electroless plating method, comprising:
a tin treatment step of bringing a substrate into contact with a tin compound aqueous solution containing a tin compound;
after the tin treatment step, a copper treatment step of bringing the substrate into contact with a copper compound aqueous solution containing a copper compound;
an oxidation treatment step of irradiating ultraviolet rays to an arbitrary portion of metal copper formed on the substrate by deposition so as to oxidize an exposed portion of the metal copper;
a diluted sulfuric acid treatment step of bringing the substrate into contact with diluted sulfuric acid to remove oxide copper so as to form the metal copper into an arbitrary pattern; and
a plating treatment step of bringing the substrate into contact with a plating solution to form a plating film using the metal copper as nuclei.

10. The method for forming a circuit using an electroless plating method, according to Claim 9, wherein the wavelength of the ultraviolet rays used in the oxidation treatment step is 254 nm or less.

11. The method for forming a circuit using an electroless plating method, according to Claim 9 or 10, further comprising, after the diluted sulfuric acid treatment step and before the plating treatment step, a palladium treatment step of bringing the substrate into contact with a palladium solution containing palladium.
